# EUROPÄISCHE PATENTSCHRIFT

(11) **EP 3 102 994 B1**
(45) Veröffentlichungstag und Bekanntmachung des Hinweises auf die Patenterteilung: **07.08.2019**
(21) Anmeldenummer: 15705494.1
(22) Anmeldetag: 02.02.2015
(51) Int. Cl.: G06F 1/20, H05K 7/20

(54) **BELÜFTUNGSVORRICHTUNG**
VENTILATION DEVICE
DISPOSITIF DE VENTILATION

(30) Priorität: 03.02.2014 DE 102014001423
(43) Veröffentlichungstag der Anmeldung: 14.12.2016
(73) Patentinhaber: Unify GmbH & Co. KG, 80807 München (DE)
(72) Erfinder: KRUSE, Thomas, 58454 Witten (DE)
(74) Vertreter: Fritzsche, Thomas
(86) Internationale Anmeldenummer: PCT/EP2015/000202
(87) Internationale Veröffentlichungsnummer: WO 2015/113775

(56) Entgegenhaltungen:
- US-A- 5 694 294
- US-A1- 2007 072 443
- US-A1- 2008 180 910
- US-A1- 2011 079 374
- US-B1- 6 252 770
- US-B1- 6 594 148

## Beschreibung

Die Erfindung betrifft eine Belüftungsvorrichtung. Insbesondere betrifft die Erfindung eine Belüftungsvorrichtung zum Belüften einer Leiterplatte, vorzugsweise in einem Computer.

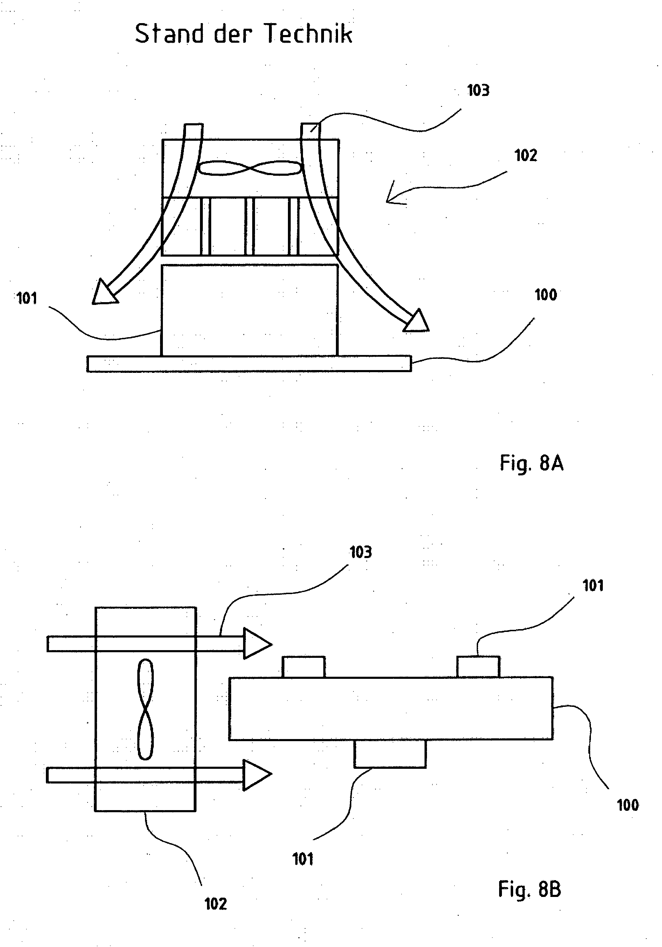

Zur Belüftung einer Leiterplatte bzw. von Bauelementen einer Leiterplatte sind verschiedene Anordnungen bekannt. Solche Anordnungen nach dem Stand der Technik sind beispielsweise in Figuren 8A und 8B gezeigt. Solche Anordnungen nach dem Stand der Technik sind beispielsweise auch aus den Druckschriften US 2005/0199369 A1 und US 2006/0146494 A1 und US 6594148 B1 bekannt.

Aus der Druckschrift US 2005/0199369 A1 ist zusätzlich eine Belüftungsvorrichtung bekannt, die mittels eines ersten Lüfters einen ersten Kühlluftstrom und mittels eines zweiten Lüfters einen zweiten Kühlluftstrom erzeugt.

Die Druckschrift US 2006/0146494 A1 offenbart auch eine Belüftungsvorrichtung mit einem Gehäuse, das eine Belüftungsseite aufweist, welche eine Belüftungsebene definiert und an welcher das Gehäuse wenigstens teilweise offen ist.

Aus der Druckschrift US 6594148 B1 ist ein Hochleistungs-Multi-direktionales Airflow-System für eine Telekommunikationsausrüstungseinheit, die für das Gehäuse elektronischer Geräte verwendet wird, die die Telekommunikationsfunktionalität erleichtern.

Weiterhin werden weitere Belüftungsvorrichtungen mit Lüftern in der Druckschriften US 2008/0180910 A1 für elektronische Elemente in einem Mikroprozessor und in der Druckschrift US 2011/0079374 A1 für elektronische Elemente in einem transportablen elektronischen Apparat offenbart.

Fig. 8A zeigt eine Leiterplatte 100 mit einem Bauteil 101. Das Bauteil 101 ist in diesem Beispiel eine Zentrale Prozessoreinheit (CPU). Es ist bekannt, das Bauteil 101 durch einen aufgesetzten Lüfter 102 zu kühlen, der einen Luftstrom 103 von oben ansaugt und nach unten direkt auf das Bauteil 101 strömen lässt. Nach Überströmen des Bauteils 101 wird der Luftstrom 103 durch die Leiterplatte 100 abgelenkt und über die Leiterplatte 100 geführt. Fig. 8B zeigt eine weitere Leiterplatte 100, die auf beiden Seiten mit Bauteilen 101 bestückt ist. Seitlich der Leiterplatte ist ein Lüfter 102 angeordnet, der einen Luftstrom 103 auf eine Seitenkante der Leiterplatte 100 richtet, wo der Luftstrom geteilt wird und an Ober- und Unterseite der Leiterplatte 100 entlang strömt, um die Bauteile 101 zu kühlen.

Das Raumangebot innerhalb eines Rechnergehäuses kann begrenzt sein. Insbesondere ist es bekannt, dass eine Mehrzahl von Platinen in Steckleisten (sog. "Slots") mit vorbestimmtem, mitunter geringem Abstand eingebaut sind. Belüftungsvorrichtungen der beschriebenen Art weisen aber eine vergleichsweise großen Bauhöhe in Bezug auf die Dicke der bestückten Leiterplatte auf oder sind auf den Bauelementen, die auf der Leiterplatte angebracht sind, noch zusätzlich oben aufgesetzt, was den Einsatz dieser Belüftungsarten oft problematisch macht. Beispielsweise ist in OSBiz-Wandsystemen der Baureihe X3/X5 der Anmelderin insbesondere bei Einsatz einer UC-Booster-Card aufgrund hoher Bauteildichte und beidseitiger Bestückung und in Verbindung mit einer temperaturempfindlichen Festplatte eine Zwangsbelüftung im Gehäuse wünschenswert, da die Eigenkonvektion innerhalb des Gehäuses an ihre Grenzen stößt. Eine Änderung am Gehäuse, an der Hauptplatine oder an der Einbaulage ist schwierig zu verwirklichen. Besonders kritisch ist hierbei die Festplatte, wobei eine Grenztemperatur, die nicht überschritten werden soll, beispielsweise 55 °C, schwankend je nach Hersteller, betragen kann.

Es ist eine Aufgabe der vorliegenden Erfindung, eine Belüftungsvorrichtung für eine Leiterplatte zu schaffen, welche die Nachteile im Stand der Technik wenigstens teilweise beseitigt. Insbesondere besteht eine Aufgabe der Erfindung darin, eine Belüftungsvorrichtung für eine Leiterplatte zu schaffen, die eine beidseitige Belüftung einer Leiterplatte bei möglichst geringer Bauhöhe ermöglicht.

Die Aufgabe wird erfindungsgemäß durch die Merkmale der unabhängigen Ansprüche gelöst. Vorteilhafte Ausführungsformen und Weiterentwicklungen der Erfindung sind in den Unteransprüchen angegeben. Beschriebene Ausführungsarten, die nicht in den Schutzumfang der Ansprüche fallen, sind nicht Teil der beanspruchten Erfindung.

Die Erfindung geht von der Überlegung aus, zwei Lüfter neben einer Leiterplatte, also in Verlängerung einer Leiterplattenebene, anzuordnen, wobei die Lüfterachsen jeweils winklig, insbesondere senkrecht, zu der Leiterplattenebene angeordnet sind, und wobei die Luftströme der Lüfter die Leiterplattenebene queren und mittels geeigneter Luftleitelemente so umgelenkt werden, dass jeweils eine Seite der Leiterplatte durch einen der Luftströme weitgehend tangential überstrichen wird.

Somit wird nach einem Gesichtspunkt der Erfindung eine Belüftungsvorrichtung vorgeschlagen, die ausgebildet ist, um mittels eines ersten Lüfters einen ersten Kühlluftstrom zu erzeugen und mittels eines zweiten Lüfters einen zweiten Kühlluftstrom zu erzeugen, wobei der erste Kühlluftstrom und der zweite Kühlluftstrom auf unterschiedlichen Seiten einer Luftstromgrenzebene vorzugsweise parallel zu der Luftstromgrenzebene durch eine gemeinsame, zu der Luftstromgrenzebene senkrechte Belüftungsebene hindurch verlaufen, wobei Förderrichtungen des ersten Lüfters und des zweiten Lüfters quer zu der Luftstromgrenzebene verlaufen. Die Belüftungsvorrichtung ist insbesondere zum Belüften einer Leiterplatte, vorzugsweise in einem bzw. für einen Computer, ausgebildet und vorzugsweise so montierbar ausgebildet, dass die Luftstromgrenzebene mit einer Mittelebene der Leiterplatte zusammenfällt.

Eine Belüftungsebene ist im Sinne der Erfindung eine Ebene, die einem zu belüftenden Gegenstand zugewandt ist und durch welche die Kühlluftströme hindurchtreten, um die Belüftung des Gegenstands zu besorgen. Eine Luftstromgrenzebene ist im Sinne der Erfindung eine Ebene, welche wenigstens unmittelbar nach Verlassen der Belüftungsvorrichtung als eine Grenze zwischen den beiden Kühlluftströmen festgestellt werden kann. Dies bedeutet, dass ein der Belüftungsvorrichtung unmittelbar benachbartes Bauteil, das sich in der Luftstromgrenzebene befindet, von Kühlluftströmen jeweils einer Seite der Luftstromgrenzebene tangential beströmt wird. Es versteht sich, dass sich die Kühlluftströme in einem gewissen Abstand von der Belüftungsvorrichtung vermischen können, wenn die Trennung der Kühlluftströme nicht durch einen in der Luftstromgrenzebene befindlichen Gegenstand aufrechterhalten wird. Quer zur Luftstromgrenzebene ist im Sinne der Erfindung als nichtparallel, also schräg oder, was bevorzugt ist, senkrecht oder im Wesentlichen senkrecht zur Luftstromgrenzebene zu verstehen. Mit anderen Worten, der erste und der zweite Kühlluftstrom werden durch die Belüftungsvorrichtung von der Querrichtung um 90° ± x (je nach Schrägstellung der Lüfter) so umgelenkt, um parallel zueinander oder im Wesentlichen parallel zueinander entlang der Luftstromgrenzebene, die im Einsatz beispielsweise mit einer Leiterplattenebene zusammenfällt, zu verlaufen. Da Lüfter üblicherweise von flacher Bauweise, d.h., in Förderrichtung von geringerer Ausdehnung als quer dazu sind, ermöglicht die schräge, insbesondere um 90 ° gekippte Anordnung mit anschließender Strömungsumlenkung einen flachen Einbau der Lüfter in Bezug auf Belüftungsrichtung. Dadurch kann auch Bauhöhe eingespart werden. Zwei Seiten eines Gegenstands, insbesondere einer Leiterplatte, sind gezielt belüftbar, und die Luftströme werden so gelenkt, dass der erste Kühlluftstrom entlang einer ersten Leiterplattenflachseite der Leiterplatte und der zweite Kühlluftstrom entlang einer zweiten Leiterplattenflachseite der Leiterplatte verlaufen. Als Luft wird im Sinne der Erfindung jedes Kühlgasgemisch verstanden, insbesondere Umgebungsluft. Als eine Leiterplatte wird im Sinne der Erfindung i. A. ein flaches Bauteil mit zwei Flachseiten (Leiterplattenflachseiten bzw. Bestückseiten) und üblicherweise vier Randseiten verstanden. Freilich sind auch Leiterplatten mit einer (z. B. rund, oval oder dergleichen), zwei (B. lanzettförmig), drei oder fünf oder mehr Randseiten denkbar. Beide Leiterplattenflachseiten können bestückt sein, die Wirkung der Erfindung kann indessen auch ausgenutzt werden, wenn nur eine Seite bestückt ist, aber Wärme auch auf die andere Seite geleitet wird. Insbesondere ist auch denkbar, dass ein Wärme erzeugendes Bauteil in einem Ausschnitt der Leiterplatte angeordnet ist und nach beiden Flachseiten Wärme abgeben kann. Die Belüftungsebene kann zu der Leiterplatte hin weisen.

Gemäß einer bevorzugten Ausführungsform der Belüftungsvorrichtung sind der erste Kühlluftstrom und der zweite Kühlluftstrom Druckströme oder Saugströme des ersten Lüfters bzw. des zweiten Lüfters. Mit anderen Worten, die Luftströme treten in gleicher Vorzugsrichtung durch die Belüftungsebene hindurch. Dabei ist ein Saugstrom der von einem Lüfter aufgenommene Luftstrom, ein Druckstrom der von einem Lüfter abgegebene Luftstrom. Da der erste und der zweite Kühlluftstrom im Wesentlichen gleichsinnig bezüglich einer Hauptströmungsrichtung parallel zu der Luftstromgrenzebene verlaufen, kann auch eine vergleichsweise große Luftmenge an dem zu belüftenden Gegenstand entlang gefördert werden, wobei auch ein wenigstens im Wesentlichen einheitliches Temperaturprofil auf Vorder- und Rückseite des Gegenstands erzielt werden kann. Unter der Hauptströmungsrichtung wird eine Achse verstanden, die senkrecht zu der Belüftungsebene innerhalb der Luftstromgrenzebene verläuft. Dabei können die Kühlluftströme seitliche Winkelabweichungen von der Hauptströmungsrichtung aufweisen und auch fächerförmig verlaufen.

Gemäß einer alternativen bevorzugten Ausführungsform der Belüftungsvorrichtung ist der erste Kühlluftstrom ein Druckstrom des ersten Lüfters oder des zweiten Lüfters und ist der zweite Kühlluftstrom ein Saugstrom des anderen des ersten Lüfters und des zweiten Lüfters. Mit anderen Worten, die Luftströme treten in entgegengesetzten Vorzugsrichtungen durch die Belüftungsebene hindurch. Dadurch verlaufen der erste und der zweite Kühlluftstrom wenigstens im Wesentlichen gegensinnig bezüglich einer Hauptströmungsrichtung parallel zu der Luftstromgrenzebene. Auf diese Weise wird eine Push-Pull-Anordnung verwirklicht. So kann beispielsweise dann, wenn die Luftströme auf der stromabwärtigen Seite des belüfteten Gegenstands nicht entweichen können, eine Umströmung des Gegenstands derart erreicht werden, dass der entlang einer ersten Seite des Gegenstands strömende erste Kühlluftstrom (Druckstrom) am Ende umgelenkt wird und entlang der zweiten Seite des Gegenstands als zweiter Kühlluftstrom strömt und durch den zweiten Lüfter angesaugt wird (Saugstrom).

Gemäß einer bevorzugten Ausführungsform weist die Belüftungsvorrichtung ein Gehäuse mit einer Belüftungsseite, welche eine bzw. die Belüftungsebene definiert und an welcher das Gehäuse wenigstens teilweise offen ist, und eine Trägerplatte, welche die Belüftungsseite teilt und eine bzw. die Luftstromgrenzebene definiert, auf, wobei die Trägerplatte wenigstens zwei Lüfter derart trägt oder zur Aufnahme wenigstens zweier Lüfter derart ausgebildet ist, dass durch jeden Lüfter ein Kühlluftstrom durch eine jeweilige Öffnung der Trägerplatte hindurch gefördert wird bzw. förderbar ist, wobei jedem der Lüfter eine jeweilige Luftleitkammer zugeordnet ist, die zu der Belüftungsseite hin offen und zu allen anderen Seiten hin mit Ausnahme der jeweiligen Öffnung der Trägerplatte geschlossen oder im Wesentlichen geschlossen ist. Die Aufgabe der vorliegenden Erfindung wird durch diese Vorrichtung aus denselben Gründen gelöst, wie diese weiter oben für die dortige Belüftungsvorrichtung angegeben wurden. Als eine Luftleitkammer wird im Sinne der Erfindung eine durch Teile des Gehäuses gebildete Kammer verstanden, welche durch die Lüfter geförderte Luftströme so umleitet, dass ihre Strömungswege durch die Belüftungsebene hindurch verlaufen. Auf diese Weise können die erfindungsgemäßen Luftstromverläufe vorteilhaft verwirklicht werden.

Gemäß einer bevorzugten Ausführungsform der Belüftungsvorrichtung sind die Lüfter auf unterschiedlichen Seiten der Trägerplatte vorgesehen. Mit anderen Worten, die Belüftungseinrichtung bzw. die Trägerplatte ist so ausgebildet, dass die Lüfter auf unterschiedlichen Seiten der Trägerplatte anbringbar bzw. angebracht oder im Wesentlichen auf unterschiedlichen Seiten der Trägerplatte anbringbar bzw. angebracht sind. Vorzugsweise sind die Lüfter auf der jeweiligen der Luftleitkammer gegenüberliegenden Seite der Trägerplatte angeordnet, sodass die Luft jeweils ungehindert in der Luftleitkammer strömen kann. Es ist aber auch denkbar und von der Erfindung umfasst, dass ein oder die Lüfter jedenfalls teilweise durch die Öffnung in der Trennplatte hindurch ragt bzw. ragen, was die Bauhöhe der Belüftungsvorrichtung weiter verringern kann.

Gemäß einer bevorzugten Weiterbildung der Belüftungsvorrichtung ist jede Luftleitkammer eines der Lüfter auf ihrer Seite der Trägerplatte von einem Bereich eines anderen der Lüfter abgeteilt, wobei zum Abteilen insbesondere jeweils eine Trennwand vorgesehen ist, welche sich vorzugsweise senkrecht auf der Trägerplatte und besonders bevorzugt schräg zu der Belüftungsseite erstreckt. Mit anderen Worten, auf einer Seite der Trägerplatte ist eine der Luftleitkammern für einen der Lüfter ausgebildet, beispielsweise durch geeignete Stege, Deckseiten etc., und von einem Bereich des jeweils anderen Lüfters durch die Trennwand abgetrennt. Dabei ist eine Schrägstellung der Trennwände insbesondere so gewählt, dass sich die Luftleitkammern zu der Belüftungsseite der Belüftungsvorrichtung hin erweitern. Hierdurch kann auch ein fächerförmiger, sich parallel zur Luftstromgrenzebene ausbreitender Strömungsverlauf der Kühlluftströme erreicht werden. Wenn die Lüfter bezüglich der Schmalseite der Leiterplatte nebeneinander angeordnet sind, kann dadurch auch wenigstens im Wesentlichen die gesamte Breite der Leiterplatte durch die Kühlluftströme abgedeckt werden. Wenn in einer Ausführungsvariante die Lüfter nicht neben-, sondern hintereinander angeordnet sind, was bei sehr schmalen Leiterplatten wünschenswert sein kann, kann durch geeignete Formgebung der Trennwand die Nebenkammer des der Belüftungsseite näheren Lüfters so innerhalb der Luftleitkammer des ferneren Lüfters untergebracht werden, dass die Nebenkammer des der Belüftungsseite näheren Lüfters von dem Kühlluftstrom des ferneren Lüfters umströmt wird. Somit kann durch die Trennwände auch eine wirksame Trennung und geeignete Führung der Luftströme erzielt werden.

Gemäß einer bevorzugten Ausführungsform der Belüftungsvorrichtung ist die Trägerplatte ein Abschnitt einer Leiterplatte, insbesondere der zu belüftenden Leiterplatte. Mit anderen Worten, die Leiterplatte weist einen Bereich auf, in welchem die Öffnungen für die Lüfter ausgebildet sind, die Lüfter sind direkt auf der Leiterplatte anbringbar oder angebracht, und ein Gehäuse bzw. Gehäuseteile, welche die Kammern zur Lenkung des Luftstroms bilden, sind an der Leiterplatte anbringbar bzw. angebracht. Bei dieser Ausführungsform sind auch weniger Bauteile erforderlich, und die Leiterplatte ist für eine Belüftung vorkonfiguierbar. Gehäuse/-teile/-hälften und Lüfter können im Bausatz mitgeliefert werden. Die Montage ist einfacher und sicherer, und eine Lageausrichtung zwischen Belüftungsvorrichtung und Leiterplatte ist nicht mehr erforderlich.

Bevorzugten Ausführungsformen der Belüftungsvorrichtung zeichnen sich dadurch aus, dass das Gehäuse wenigstens einen der folgenden Werkstoffe aufweist oder daraus hergestellt ist oder im Wesentlichen hergestellt ist:
- Kunststoff, insbesondere ABS (Acrylnitril-Butadien-Styrol), PC (Polycarbonat) oder ein Gemisch davon,
- Leiterplattenmaterial,
- Metall, insbesondere Aluminium oder Stahlblech,
- Karton, Papier, Pappe oder dergleichen.

Gemäß einer bevorzugten Ausführungsform der Belüftungsvorrichtung ist zur elektrischen Stromversorgung der Lüfter ein symmetrischer Anschluss vorgesehen, wobei der Anschluss vorzugsweise einen gemeinsamer Minuspol als Masse und jeweilige Pluspole als Versorgungspotential jeweils eines der Lüfter in symmetrischer Anordnung um den Minuspol herum aufweist. Symmetrisch ist in diesem Zusammenhang insbesondere als elektrisch symmetrisch zu verstehen. Dadurch kann eine erhöhte Einbausicherheit erzielt werden, eine Verpolung kann vermieden werden.

Die Anschluss- und Verpolungssicherheit kann in einer bevorzugten Weiterbildung der Belüftungsvorrichtung noch verbessert werden, wenn der symmetrische Anschluss ein Formmerkmal aufweist, welches eine Anschlusslage eindeutig festlegt. Ein Formmerkmal kann beispielsweise, aber nicht nur, eine Abschrägung, eine Nut oder eine Feder, einen Stift oder eine Eintiefung, eine Nase etc. umfassen. Ebenso kann ein unterschiedlicher Abstand der Pluspole von dem Minuspol oder eine gewinkelte Anordnung der Pole als Formmerkmal vorgesehen sein. Ein zugehöriger Stecker einer Anschlussleitung kann dann das entsprechend komplementäre Formmerkmal aufweisen.

Die Aufgabe der Erfindung wird auch gelöst durch ein Verfahren zum Belüften insbesondere einer Leiterplatte vorzugsweise in einem bzw. für einen Computer, mit den folgenden Schritten: Erzeugen eines ersten Kühlluftstroms mittels eines ersten Lüfters und eines zweiten Kühlluftstrom mittels eines zweiten Lüfters, wobei der erste Kühlluftstrom und der zweite Kühlluftstrom auf unterschiedlichen Seiten einer Luftstromgrenzebene vorzugsweise parallel zu der Luftstromgrenzebene durch eine gemeinsame, zu der Luftstromgrenzebene senkrechte Belüftungsebene hindurch verlaufen, Verlaufen der Förderrichtungen des ersten Lüfters und des zweiten Lüfters quer zu der Luftstromgrenzebene, und Einstellen des Belüftens vorzugsweise derart, dass die Luftstromgrenzebene mit einer Mittelebene der Leiterplatte zusammenfällt. Die Aufgabe der vorliegenden Erfindung wird durch dieses Verfahren aus denselben Gründen gelöst, wie diese weiter oben für die dortige Belüftungsvorrichtung angegeben wurden.

Weitere Merkmale, Aufgaben, Vorteile und Einzelheiten der vorliegenden Erfindung werden aus der nachstehenden Beschreibung konkreter Ausführungsbeispiele und ihrer zeichnerischen Darstellung in den beigefügten Figuren noch deutlicher werden. Es versteht sich, dass Merkmale, Aufgaben, Vorteile und Einzelheiten einzelner Ausführungsbeispiele auf andere Ausführungsbeispiele übertragbar sind und auch im Zusammenhang mit den anderen Ausführungsbeispielen als offenbart gelten sollen, soweit dies nicht aus technischen oder naturgesetzlichen Gründen offensichtlich abwegig ist. Ausführungsbeispiele können miteinander kombiniert werden, und die Kombination kann ebenfalls als Ausführungsbeispiel der Erfindung verstanden werden.

Im Folgenden wird die Erfindung anhand bevorzugter Ausführungsbeispiele und mit Hilfe von Figuren näher beschrieben. Dabei ist bzw. sind
- Fig. 1: eine Darstellung einer Belüftungsvorrichtung gemäß einem ersten Ausführungsbeispiel der vorliegenden Erfindung in einer ersten Betriebsart;
- Fig. 2: eine Darstellung der Belüftungsvorrichtung gemäß dem ersten Ausführungsbeispiel in einer zweiten Betriebsart;
- Fign. 3A bis 3F: verschiedene vergrößerte Ansichten und Schnittdarstellungen der Belüftungsvorrichtung gemäß dem ersten Ausführungsbeispiel in der ersten Betriebsart;
- Fig. 4: eine räumliche Darstellung der Belüftungsvorrichtung gemäß dem ersten Ausführungsbeispiel in der zweiten Betriebsart;
- Fig. 5: eine Darstellung einer Rückseite der Belüftungsvorrichtung des ersten Ausführungsbeispiels;
- Fig. 6: eine Darstellung der Belüftungsvorrichtung gemäß einem zweiten Ausführungsbeispiel der vorliegenden Erfindung in der zweiten Betriebsart;
- Fig. 7: eine Darstellung der Belüftungsvorrichtung gemäß einem dritten Ausführungsbeispiel der vorliegenden Erfindung in der zweiten Betriebsart;
- Fign. 8A und 8B: Seitenansichten von Belüftungsvorrichtungen gemäß dem Stand der Technik.

Die Figuren sind rein schematisch und nicht notwendigerweise maßstabsgetreu. Die zeichnerischen Darstellungen und Beschreibungen hiervon sind zur beispielhaften Veranschaulichung des Prinzips der Erfindung gedacht und sollen diese in keiner Weise einschränken.

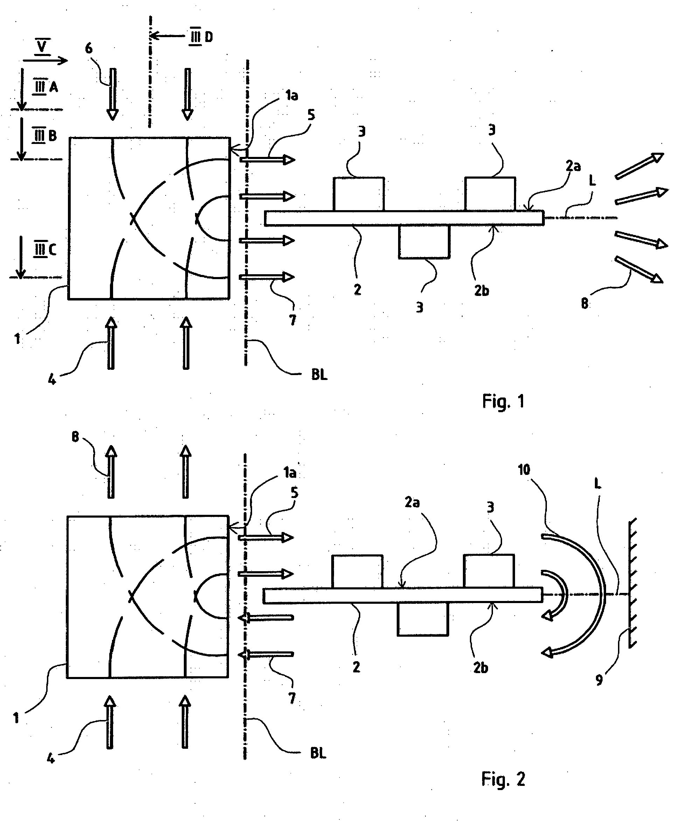

Eine grundlegende Funktionsweise einer Belüftungsvorrichtung 1 gemäß einem ersten, grundlegenden Ausführungsbeispiel wird nun anhand der Fign. 1 und 2 erläutert. Fign. 1 und 2 sind Seitenansichten der Belüftungsvorrichtung 1, die in bestimmungsgemäßer Arbeitsposition neben einer Leiterplatte 2 angeordnet ist. Luftströme sind in der Figur mit fetten Pfeilen oder, sofern von Bauteilen verdeckt, mit gestrichelten Linien dargestellt.

Gemäß der Darstellung in Fign 1 und 2 ist die Leiterplatte 2 auf einer Oberseite 2a und einer Unterseite 2b mit Bauteilen 3 bestückt und weist eine Mittelebene oder Leiterplattenebene L auf, welche in der Mitte zwischen der Oberseite 2a und der Unterseite 2b der Leiterplatte 2 verläuft. Die Belüftungsvorrichtung 1 weist eine der Leiterplatte 2 zugewandte Belüftungsseite 1a auf. Die Belüftungsseite 1a definiert eine Belüftungsebene BL, welche senkrecht zu der Leiterplattenebene L steht und durch welche Kühlluftströme, welche der Kühlung bzw. Belüftung der Leiterplatte 2 durch die Belüftungsvorrichtung 1 dienen, hindurchtreten. Die Belüftungsvorrichtung 1 weist zwei Lüfter auf, die im Inneren der Belüftungsvorrichtung 1 angeordnet sind (hier nicht sichtbar). Dabei ist die Belüftungsvorrichtung 1 grundsätzlich in zwei Betriebsarten betreibbar, die nun im Einzelnen erläutert werden.

In Fig. 1 ist eine erste Betriebsart der Belüftungsvorrichtung 1 dargestellt. Dabei wird ein Frischluftstrom 4 durch eine hier nicht näher dargestellte Öffnung an der Unterseite der Belüftungsvorrichtung 1 angesaugt, innerhalb der Belüftungsvorrichtung 1 durch geeignete Luftführungselemente umgelenkt und oberhalb der Leiterplattenebene L als ein erster Kühlluftstrom 5 durch eine hier nicht näher dargestellte Öffnung auf der Belüftungsseite 1a der Belüftungsvorrichtung 1 so abgegeben, dass er die Belüftungsvorrichtung 1 unter Hindurchtreten durch die Belüftungsebene BL parallel zu der Leiterplattenebene L an der Oberseite 2a der Leiterplatte 2 verlässt. Gleichermaßen wird ein zweiter Frischluftstrom 6 durch eine hier nicht näher dargestellte Öffnung an der Oberseite der Belüftungsvorrichtung 1 angesaugt, innerhalb der Belüftungsvorrichtung durch geeignete Luftführungselemente umgelenkt und unterhalb der Leiterplattenebene L als ein zweiter Kühlluftstrom 7 zur Belüftung der Unterseite 2b der Leiterplatte 2 durch eine hier nicht näher dargestellte Öffnung an der Belüftungsseite 1a der Belüftungsvorrichtung 1 so abgegeben, dass er die Belüftungsvorrichtung 1 unter Hindurchtreten durch die Belüftungsebene BL parallel zu der Leiterplattenebene L an der Unterseite 2b der Leiterplatte 2 verlässt. Die Leiterplattenebene L kann somit auch als Luftstromgrenzebene L bezeichnet werden, welche eine Grenze zwischen dem ersten Kühlluftstrom 5 und dem zweiten Kühlluftstrom 7 bildet. Nach Überströmen der Leiterplatte 2 vereinigen sich der erste Kühlluftstrom 5 und der zweite Kühlluftstrom 7 zu einem Abluftstrom 8, der beispielsweise ein hier nicht näher dargestelltes Rechnergehäuse durch nicht näher dargestellte Lüftungsschlitze verlassen kann. Es ist anzumerken, dass die Luftstromgrenzebene L auch dann durch die zunächst getrennten Kühlluftströme 5, 7 festgestellt werden kann, wenn die Leiterplatte 2 nicht vorhanden ist; freilich werden sich die Kühlluftströme 5, 7 dann gegebenenfalls früher vereinigen. Die erste Betriebsart kann auch als eine Anblasbelüftung (Push-Belüftung) bezeichnet werden. Die Richtung der Frischluftströme 4, 6 ist vorzugsweise so gewählt, dass eine Thermik im umgebenden Raumvolumen (etwa ein Computergehäuse) unterstützt oder ausgenutzt wird.

In einer Abwandlung der ersten Betriebsart können beide Lüfter in umgekehrter Richtung arbeiten, sodass Luftströme von Oberseite 2a und Unterseite 2b der Leiterplatte 2 durch die Belüftungsebene BL hindurch angesaugt und an Ober- und Unterseite der Belüftungsvorrichtung 1 als Abluftströme abgegeben werden. Diese abgewandelte Betriebsart kann auch als eine Absaugbelüftung (Pull-Belüftung) bezeichnet werden. Sie kann durch eine Umkehrung aller Luftstrompfeilrichtungen in Fig. 1 verstanden werden.

In Fig. 2 ist eine zweite Betriebsart der Belüftungsvorrichtung 1 dargestellt. Dabei wird angenommen, dass hinter der Leiterplatte 2, d.h., auf einer der Belüftungsvorrichtung 1 entgegengesetzten Schmalseite der Leiterplatte 2, eine Gehäusewand 9 eines Computers oder ein anderes Hindernis angeordnet ist, welche ein freies Abströmen eines Abluftstroms behindern würde. In der zweiten Betriebsart arbeitet ein erster Lüfter wie in der ersten Betriebsart im Push-Betrieb, d. h. ein Frischluftstrom 4 wird durch die Öffnung an der Unterseite der Belüftungsvorrichtung 1 angesaugt, umgelenkt und oberhalb der Leiterplattenebene L als ein erster Kühlluftstrom 5 parallel zu der Oberseite 2a der Leiterplatte 2 abgegeben. Anders als in der ersten Betriebsart arbeitet in der zweiten Betriebsart ein zweiter Lüfter im Pull-Betrieb, d.h., ein zweiter Kühlluftstrom 7, der an der Unterseite 2b der Leiterplatte 2 entlang strömt, wird durch die Belüftungsebene BL hindurch in die Belüftungsvorrichtung 1 angesaugt, dort umgelenkt und durch die Öffnung an der Oberseite der Belüftungsvorrichtung 1 als der Abluftstrom 8 abgegeben. Der zweite Kühlluftstrom 7, der die Unterseite 2b der Leiterplatte 2 belüftet, ergibt sich dabei wenigstens zum Teil aus dem ersten Kühlluftstrom 5, der an der Wand 9 in einem Umlenkstrom 10 umgelenkt wird. Das Ansaugen und Umlenken des zweiten Luftstroms 7 erfolgt durch den gleichen Lüfter und die gleichen Luftführungselemente, die in der ersten Betriebsart den zweiten Frischluftstrom 6 (Fig. 1) ansaugen und umlenken, nur dass der hierzu verwendete Lüfter in anderer Richtung betrieben wird. Die Umlenkung des ersten Kühlluftstroms 5 in den Umlenkstrom 10 wird dabei durch die Saugwirkung des im Pull-Betrieb arbeitenden Lüfters unterstützt. Die zweite Betriebsart kann auch als eine Push-Pull-Belüftung bezeichnet werden. Es versteht sich, dass auch in dieser Betriebsart die Arbeitsrichtungen der Lüfter umgekehrt werden können, sodass sich alle Strömungsrichtungen umkehren.

In beiden Betriebsarten werden der erste und der zweite Kühlluftstrom 5, 7 von jeweiligen Lüftern der Belüftungsvorrichtung 1 erzeugt. Gegebenenfalls sind die Lüfter unterschiedlich zu dimensionieren, insbesondere kann es sinnvoll sein, einen Lüfter, der entgegen der Thermik im umgebenden Raumvolumen arbeitet, kräftiger auszulegen. In jedem Fall ist der Strömungsverlauf so zu gestalten, dass ein Kurzschluss zwischen Frischluft und Abluft vermieden oder im Wesentlichen vermieden wird.

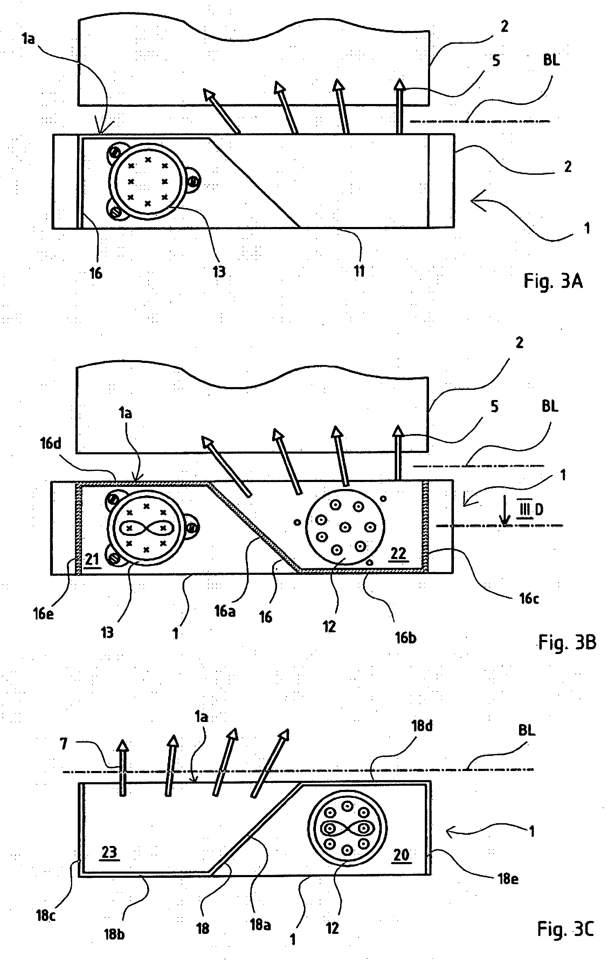

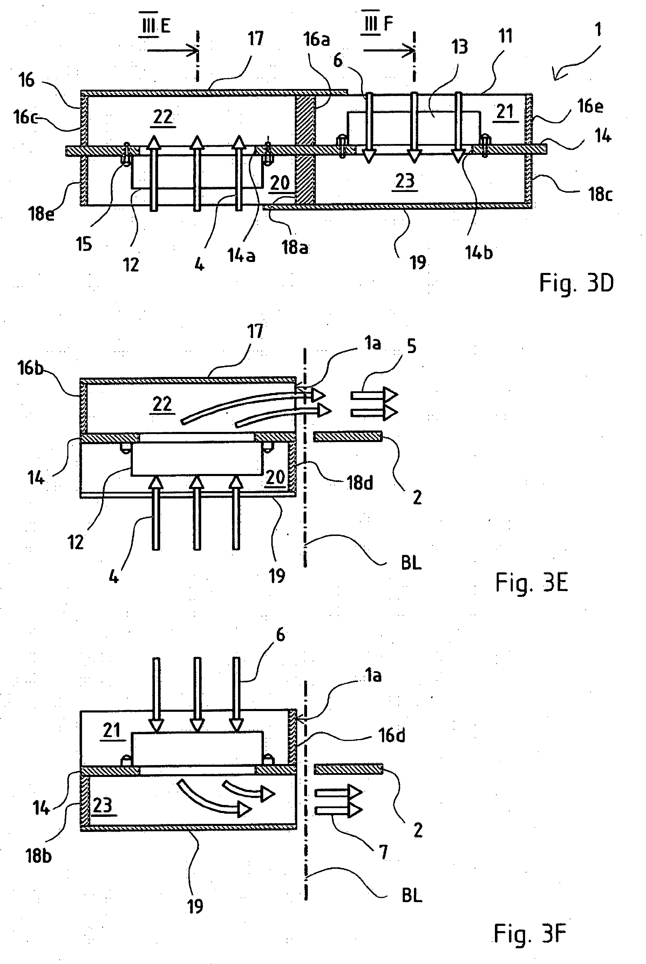

Ein innerer Aufbau der Belüftungsvorrichtung 1 wird nun anhand der Darstellung in Fign. 3A bis 3F genauer dargestellt. Dabei zeigt Fig. 3A eine Draufsicht in einer Ebene und einer Richtung, die in Fig. 1 mit einer strichpunktierten Linie und einen Pfeil IIIA angegeben sind, zeigt Fig. 3B eine Schnittansicht von oben in einer Ebene und einer Richtung, die in Fig. 1 mit einer strichpunktierten Linie und einen Pfeil IIIB angegeben sind, d.i. oberhalb der Luftstromgrenzebene L, zeigt Fig. 3C eine Schnittansicht von oben in einer Ebene und einer Richtung, die in Fig. 1 mit einer strichpunktierten Linie und einen Pfeil IIIC angegeben sind, d.i. unterhalb der Luftstromgrenzebene L, zeigt Fig. 3D eine Querschnittansicht aus Richtung der Leiterplatte 2 in einer Ebene und einer Richtung, die in Fig. 1 und Fig. 3B mit einer strichpunktierten Linie und einen Pfeil IIID angegeben sind, zeigt Fig. 3E eine Schnittansicht von der Seite in einer Ebene und einer Richtung, die in Fig. 3D mit einer strichpunktierten Linie und einen Pfeil IIIE angegeben sind, und zeigt Fig. 3F eine Schnittansicht von der Seite in einer Ebene und einer Richtung, die in Fig. 3D mit einer strichpunktierten Linie und einen Pfeil IIIF angegeben sind. Die Belüftungsvorrichtung 1 ist in allen Fign. 3A-3F in der ersten Betriebsart gemäß Fig. 1 gezeigt.

Fig. 3A zeigt die Belüftungsvorrichtung 1 von oben mit einem Abschnitt der Leiterplatte 2. Wie in Fig. 3A gezeigt, verlässt der erste Kühlluftstrom 5 die Belüftungsvorrichtung 1 auf der Belüftungsseite 1a in einem fächerförmigen Verlauf derart, dass sich der Kühlluftstrom 5 von der rechten Seite aus zur Mitte hin auffächert. Der unterhalb der Leiterplatte 2 verlaufende Kühlluftstrom (7, Fig. 1) ist in Fig. 3A nicht dargestellt, er verläuft aber, wie in weiteren Figuren deutlich wird, ebenfalls fächerförmig mit entgegengesetzter Auffächerungsrichtung. Im Weiteren wird die Belüftungsseite 1a auch als vorne, die entgegengesetzte Seite als hinten bezeichnet.

Wie am besten in Fig. 3D, welche einen etwa mittigen Querschnitt parallel zur Belüftungsebene (Fign. 1) zeigt, ersichtlich, weist die Belüftungsvorrichtung 1 ein Gehäuse 11, einen ersten Lüfter 12 und einen zweiten Lüfter 13 auf. Das Gehäuse 11 weist eine Trägerplatte 14 auf, welche die Luftstromgrenzebene (L, Fig. 1) bildet und eine erste Öffnung 14a und eine zweite Öffnung 14b aufweist. Der erste Lüfter 12 ist mittels Schrauben 15 im Bereich der ersten Öffnung 14a an einer Unterseite der Trägerplatte 14 befestigt, und der zweite Lüfter 13 ist mittels Schrauben 15 im Bereich der zweiten Öffnung 14b an einer Oberseite der Trägerplatte 14 befestigt. An der Oberseite der Trägerplatte 14 ist senkrecht abstehend ein erster Steg 16 angeordnet, der durch eine erste Deckplatte 17, die parallel zu der Trägerplatte 14 verläuft, teilweise nach oben hin bedeckt ist. Gleichermaßen ist an der Unterseite der Trägerplatte 14 senkrecht abstehend ein zweiter Steg 18 angeordnet, der durch eine zweite Deckplatte 19, die parallel zu der Trägerplatte 14 verläuft, teilweise nach unten hin bedeckt ist.

Der Verlauf des ersten Stegs 16 ist am besten in Fig. 3B ersichtlich, welche die Belüftungsvorrichtung 1 in einem Horizontalschnitt oberhalb der Leiterplatte 2 (der Luftstromgrenzebene L, Fig. 1) zeigt. Der erste Steg 16 weist eine Trennwand 16a auf, welche diagonal zwischen den Öffnungen 14a, 14b über die Deckplatte 14 verläuft und somit einen Bereich der ersten Öffnung 14a von einem Bereich der zweiten Öffnung 14b oberhalb der Deckplatte 14 trennt. Im Weiteren wird der Bereich der ersten Öffnung 14a auch als Bereich des ersten Lüfters 12 bezeichnet und wird der Bereich der zweiten Öffnung 14b auch als Bereich des zweiten Lüfters 13 bezeichnet, wobei die Bereiche der Lüfter 12, 13 in einer Richtung senkrecht zur Trägerplatte 14 ausgedehnt und durch die Stege 16, 18 umgrenzt zu verstehen sind. Im Bereich des ersten Lüfters 12 (der ersten Öffnung 14a) schließt sich an die Trennwand 16a an einer Hinterkante der Deckplatte 14 entlang eine Rückwand 16b und im weiteren Verlauf, rechtwinklig nach vorn abknickend, eine Seitenwand 16c an. Im Bereich des zweiten Lüfters 13 (der zweiten Öffnung 14b) schließt sich an die Trennwand 16a an der Vorderkante (Belüftungsseite 1a, vgl. Fig. 3A) der Deckplatte 14 entlang eine Vorderwand 16d und im weiteren Verlauf, rechtwinklig nach hinten abknickend, eine weitere Seitenwand 16e an. Mit anderen Worten, der erste Steg 16 verläuft in einer eckigen S-Form derart, dass der Bereich des ersten Lüfters 12 (der ersten Öffnung 14a) zur Belüftungsseite 1a hin offen ist, der Bereich des zweiten Lüfters 13 (der zweiten Öffnung 14b) zur Belüftungsseite 1a hin abgeschlossen ist. Dabei erweitert sich aufgrund der diagonalen Anordnung der ersten Trennwand 16a der Bereich des ersten Lüfters 12 zur Vorderkante (Belüftungsseite 1a, vgl. Fig. 3A) hin. Wie in Fign. 3A, 3D, 3E und 3F dargestellt, ist die erste Deckplatte 17 nur im Bereich des ersten Lüfters 12, d.h., nur auf der ersten Trennwand 16a, der Rückwand 16b und der sich daran anschließenden Seitenwand 16c, vorgesehen, während der Bereich des zweiten Lüfters 13, d.h., der Bereich der Vorderwand 16d und der sich daran anschließenden, weiteren Seitenwand 16e, nach oben offen ist.

Der Verlauf des zweiten Stegs 18 ist am besten in Fig. 3C ersichtlich, welche die Belüftungsvorrichtung 1 in einem Horizontalschnitt unterhalb der Leiterplatte 2 (der Luftstromgrenzebene L, Fig. 1) zeigt. Der zweite Steg 18 weist eine Trennwand 18a auf, welche diagonal zwischen den Öffnungen 14b, 14a über die Deckplatte 14 verläuft und somit einen Bereich des zweiten Lüfters 13 von einem Bereich des ersten Lüfters 12 oberhalb der Deckplatte 14 trennt. Im Bereich des zweiten Lüfters 13 (der zweiten Öffnung 14b) schließt sich an die Trennwand 18a an der Hinterkante der Deckplatte 14 entlang eine Rückwand 18b und im weiteren Verlauf, rechtwinklig nach vorn abknickend, eine Seitenwand 18c an. Im Bereich des ersten Lüfters 12 (der ersten Öffnung 14a) schließt sich an die Trennwand 18a an der Vorderkante (Belüftungsseite 1a, vgl. Fig. 3A) der Deckplatte 14 entlang eine Vorderwand 18d und im weiteren Verlauf, rechtwinklig nach hinten abknickend, eine weitere Seitenwand 18e an. Mit anderen Worten, der zweite Steg 18 verläuft in einer eckigen S-Form, die der an der Ebene IIID in Fig. 3B gespiegelten S-Form ersten Stegs 16 entspricht, derart, dass der Bereich des zweiten Lüfters 13 (der zweiten Öffnung 14b) zur Belüftungsseite 1a hin offen ist, der Bereich des ersten Lüfters 12 (der ersten Öffnung 14a) zur Belüftungsseite 1a hin abgeschlossen ist. Dabei erweitert sich aufgrund der diagonalen Anordnung der zweiten Trennwand 18a der Bereich des zweiten Lüfters 13 zur Vorderkante (Belüftungsseite 1a, vgl. Fig. 3A) hin. Wie in Fign. 1, 3D, 3E und 3F dargestellt, ist die zweite Deckplatte 19 nur im Bereich des zweiten Lüfters 13, d.h., nur auf der zweiten Trennwand 18a, der Rückwand 18b und der sich daran anschließenden Seitenwand 18c, vorgesehen, während der Bereich des ersten Lüfters 12, d.h., der Bereich der Vorderwand 18d und der sich daran anschließenden, weiteren Seitenwand 18e, nach unten offen ist.

Wie in Fig. 3D am besten erkennbar, sind die Lüfter 12, 13 jeweils auf derjenigen Seite der Trägerplatte 14 angeordnet, die nach oben hin offen, also nicht durch eine Deckplatte 17 oder 19 verschlossen ist, während die von den Deckplatten 17 bzw. 19 verschlossenen Bereiche von Einbauten frei sind. Diese freien Bereiche können als Strömungsumlenkbereiche dienen, die zur Belüftungsseite 1a der Belüftungsvorrichtung 1 hin offen sind (vgl. Fign. 3E, 3F). Diese Strömungsumlenkbereiche werden im Sinne der Erfindung als Luftleitkammern bezeichnet, während die von den Lüftern 12, 13 belegten Bereiche als Nebenkammern bezeichnet werden. Demgemäß ist durch den nach unten offenen Bereich, in dem der erste Lüfter 12 untergebracht ist, eine erste Nebenkammer 20 definiert, ist durch den nach oben offenen Bereich, in dem der zweite Lüfter 13 untergebracht ist, eine zweite Nebenkammer 21 definiert, wird durch die Trägerplatte 14, den ersten Steg 16 (erste Trennwand 16a, Rückwand 16b, Seitenwand 16c) und die erste Deckplatte 17 eine erste Luftleitkammer 22 gebildet und wird durch die Trägerplatte 14, den zweiten Steg 18 (zweite Trennwand 18a, Rückwand 18b, Seitenwand 18c) und die zweite Deckplatte 19 eine zweite Luftleitkammer 23 gebildet.

Aufgrund der diagonalen und sich in Draufsicht überkreuzenden Anordnung der Trennwände 16a, 18a wird der fächerförmige, sich ebenfalls in Draufsicht überkreuzende Verlauf der Kühlluftströme 5, 7 erzielt. Es versteht sich, dass die Stege 16, 18 einteilig geformt oder mehrteilig zusammengesetzt ausgebildet sein können. Wie in Fig. 3A, 3B, 3D erkennbar, steht die Trägerplatte 14 seitlich über die Seitenwände der Stege 16, 18 hinaus, was eine Befestigung der Belüftungsvorrichtung erleichtert. Selbstverständlich ist es auch denkbar, dass die Trägerplatte 14 an anderer Stelle, etwa an der Vorder- oder Hinterseite vorsteht, oder dass andere Befestigungsmittel vorgesehen sind.

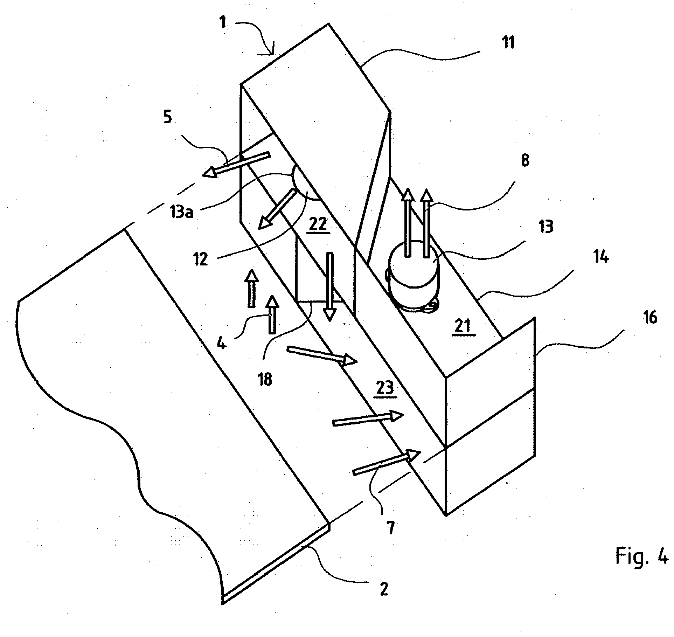

Fig. 4 zeigt eine räumliche Darstellung der Belüftungsvorrichtung 1 dieses Ausführungsbeispiels mit einem Abschnitt der Leiterplatte 2. In dieser Darstellung sind die Wege der Luftströme 4, 5, 7, 8 in der zweiten Betriebsart gemäß Fig. 2 gezeigt.

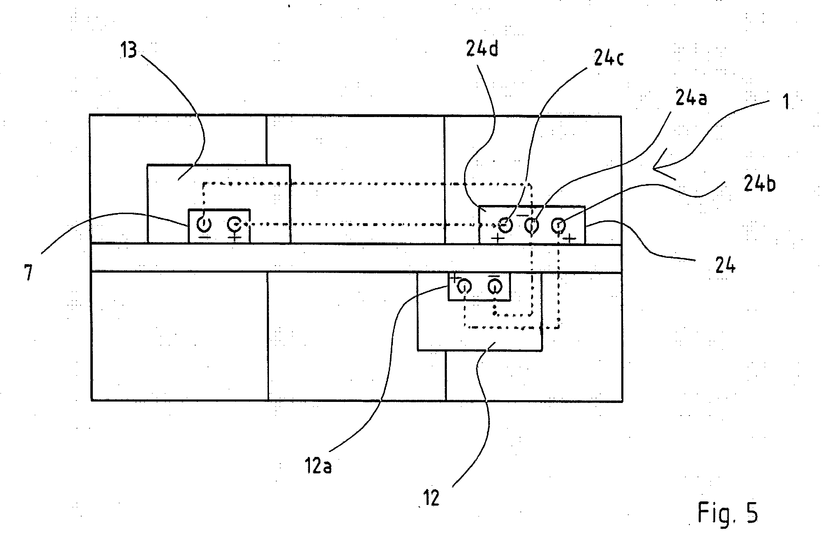

Fig. 5 zeigt eine Darstellung einer Rückseite der Belüftungsvorrichtung des ersten Ausführungsbeispiels. Gemäß der Darstellung in Fig. 5 ist ein dreipoliger, symmetrischer Anschluss 24 mit einem zentralen, gemeinsamen Masseanschluss 24a für beide Lüfter 12, 13, einem ersten Pluspol 24b zur Versorgung des ersten Lüfters 12 und einem zweiten Pluspol 24c zur Versorgung des zweiten Lüfters 13 vorgesehen. Ein erster Lüfteranschluss 12a des ersten Lüfters 12 ist mit seinem Minuspol mit dem gemeinsamen Masseanschluss 24a, mit seinem Pluspol mit dem ersten Pluspol 24b des symmetrischen Anschlusses 24 verbunden. Ein zweiter Lüfteranschluss 13a des zweiten Lüfters 13 ist mit seinem Minuspol mit dem gemeinsamen Masseanschluss 24a, mit seinem Pluspol mit dem zweiten Pluspol 24c des symmetrischen Anschlusses 24 verbunden. Anstelle eines gemeinsamen Masseanschlusses 24a kann auch ein gemeinsamer Pluspol vorliegen. Der gemeinsame Anschluss 24a kann zwischen den beiden weiteren Anschlüssen 24b, 24c derart angeordnet sein, dass ein achs- und/oder punktsymmetrischer Anschluss 24 bzw. ein achs- und/oder punktsymmetrisches Anschlusselement vorliegt, der bzw. das aufgrund seiner Symmetrie auf einer Platine/Leiterplatte verpolungssicher angebracht werden kann. Da der Anschluss 24 symmetrisch ausgeführt ist, kann auch ein passender Stecker zur (externen) Kontaktierung des Anschlusses verpolungssicher in oder an den Anschluss 24 gesteckt werden. Eine symmetrische Spannungsversorgung ist jedoch nicht zwangsläufig notwendig. In einer weiteren Ausführungsform ist die Spanungsversorgung als Parallelschaltung ausgeführt. Der/die Lüfter können zudem dreipolig (3-polig) an die Spannungsversorgung angeschlossen werden. In einem weiteren Ausführungsbeispiel der Erfindung wird außer der Spannungsversorgung zusätzlich ein Tachosignal zur Steuerung der Umdrehungszahl bzw. der Geschwindigkeit des/der Lüfter und damit des von dem Lüfter/den Lüftern bewegten Luftvolumens pro Zeiteinheit einer Steuereinheit des Lüfters/der Lüfter zur Verfügung gestellt. Über eine Auswertung des Tachosignals lässt sich die Drehzahl des Lüfters/der Lüfter kontrollieren und einstellen. Zusätzlich lässt sich feststellen und auswerten, ob ein Lüfterausfall vorliegt.

Der Anschluss 24 weist ein Formmerkmal 24d in Form einer Abschrägung an einer Ecke auf. Da an den Anschluss 24 nur ein Gegenstück mit entsprechend komplementärem Formmerkmal passt, kann auf diese Weise eine verpolungssichere Versorgung der Lüfter 12, 13 durch einen einzigen Stecker verwirklicht werden.

Da die Stege 16, 18 (Fign. 3B, 3C) im Bereich der Nebenkammern 20, 21 keine Rückwände aufweisen, sind die Lüfteranschlüsse 12a, 13a von der Rückseite der Belüftungsvorrichtung 1 gut zugänglich. Sofern es aus Gründen der Stabilität erforderlich ist, können die Stege allerdings auch im Bereich der Nebenkammern 20, 21 rückseitig weitergeführt sein. Wenn die Nebenkammer 20, 21 rückseitig ganz geschlossen sind, wären die Lüfteranschlüsse 12a, 13a immer noch von oben bzw. unten zugänglich.

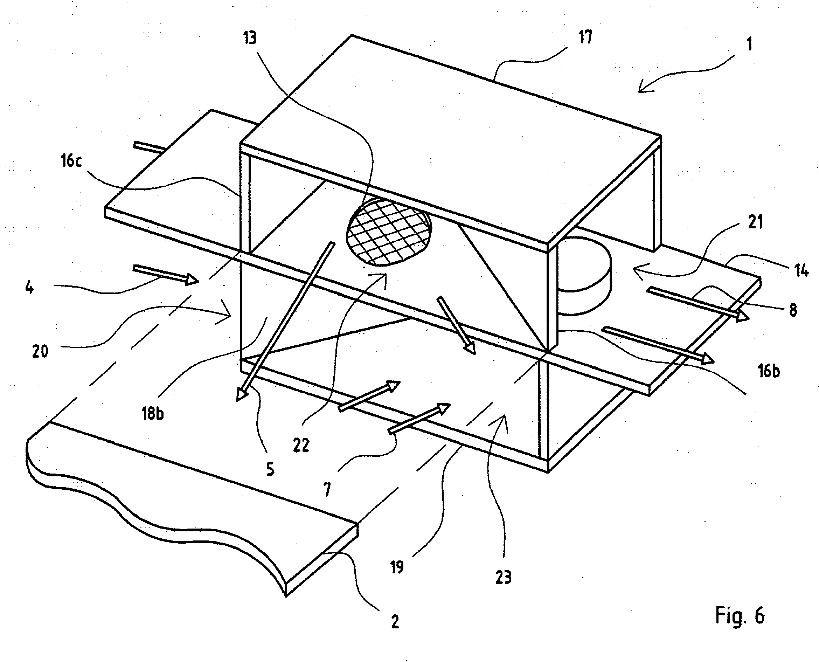

Fig. 6 zeigt eine räumliche Darstellung der Belüftungsvorrichtung 1 gemäß einem zweiten Ausführungsbeispiel der vorliegenden Erfindung in der zweiten Betriebsart. Das vorliegende Ausführungsbeispiel ist eine Abwandlung des zuvor beschriebenen ersten Ausführungsbeispiels. Soweit sich aus Nachstehendem nichts anderes ergibt, sind die Erläuterungen, Bauweisen, Wirkungen und Vorteile des ersten Ausführungsbeispiels und seiner Varianten gleichermaßen oder analog für das vorliegende Ausführungsbeispiel gültig.

Gemäß der Darstellung in Fig. 6 gehen die Deckplatten 17, 19 über die gesamte Fläche der Stege 16, 18 hinweg. Allerdings sind im Bereich der Nebenkammern 20, 21 (wo die Lüfter unterzubringen sind) die Seitenwände 16e, 18a (Fign. 3B, 3C) der Stege 16, 18 weggelassen und sind die Rückwände bis zur Seite, also auch im Bereich der Nebenkammer 20, 21 durchgezogen. Mit anderen Worten, die Nebenkammern 20, 21 sind nur seitlich nach außen hin offen. Frischluft- und/oder Abluftströme (je nach Betriebsart, hier Frischluftstrom 4 und Abluftstom 9) strömen über die offenen Seiten in oder aus den Nebenkammern 20, 21 der Belüftungsvorrichtung 1.

Diese Anordnung ist nützlich in Fällen, in denen nur seitlich von der Belüftungsvorrichtung 1 freie Luftströme möglich oder Lüftungsschlitze vorhanden sind. Dabei ist es vorteilhaft, wenn die Lüfter teilweise in den Öffnungen 14a, 14b eingelassen sind, sodass auch ein Stau in den Nebenkammern 20, 21 vermieden wird.

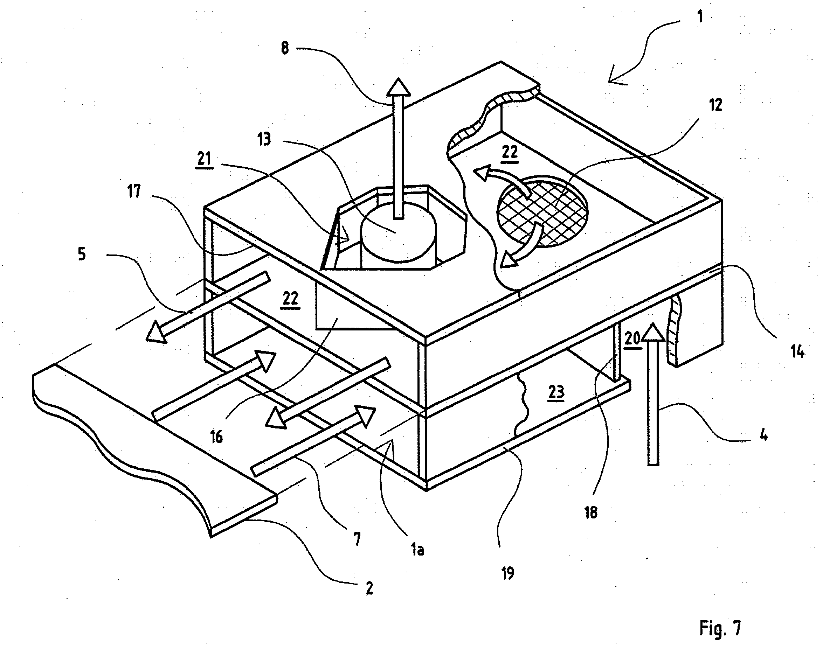

Fig. 7 zeigt eine räumliche Darstellung der Belüftungsvorrichtung gemäß einem dritten Ausführungsbeispiel der vorliegenden Erfindung in der zweiten Betriebsart. Das vorliegende Ausführungsbeispiel ist eine Abwandlung des ersten Ausführungsbeispiels. Soweit sich aus Nachstehendem nichts anderes ergibt, sind die Erläuterungen, Bauweisen, Wirkungen und Vorteile des ersten Ausführungsbeispiels und seiner Varianten und Abwandlungen gleichermaßen oder analog für das vorliegende Ausführungsbeispiel gültig.

Gemäß der Darstellung in Fig. 7 sind die Lüfter 12, 13 in Bezug auf die Leiterplatte 2 nicht nebeneinander, sondern hintereinander auf der Trägerplatte 14 angeordnet, wobei hier angenommen wird, dass der zweite Lüfter 13 der Leiterplatte 2 (Belüftungsseite 1a) näher ist als der erste Lüfter 12. Die erste Nebenkammer 20 ist somit quaderförmig im unteren hinteren Bereich vorgesehen, und die erste Luftleitkammer 22 erstreckt sich ebenfalls quaderförmig über die gesamte Länge der Belüftungsvorrichtung 1. Der erste Steg 16 ist mehrteilig und weist einen ersten Teil auf, der die erste Luftleitkammer 22 seitlich und rückseitig umschließt, und einen zweiten Teil, der ringförmig geschlossen innerhalb der ersten Luftleitkammer 22 angeordnet ist, um die zweite Nebenkammer 21 als eine Enklave innerhalb der ersten Luftleitkammer 22 auszubilden, sodass diese seitlich vom ersten Kühlluftstrom 5 umströmt wird. Hierzu ist die Ringform des die zweite Nebenkammer 21 bildenden zweiten Teils des ersten Stegs 16 strömungsgünstig einer symmetrischen Tropfenform angenähert. Die zweite Luftleitkammer 23, die wiederum quaderförmig ausgebildet ist endet vor dem Bereich des ersten Lüfters, also vor der ersten Nebenkammer 20.

Diese Anordnung ist nützlich in Fällen, in denen eine Leiterplatten 2 von einer Schmalseite her belüftet werden soll. Die Lüfter können in ihrer Leistungsstärke ggf. unterschiedlichen Strömungswiderständen angepasst sein.

Die Erfindung wurde vorstehend anhand bevorzugter Ausführungsbeispiele, - varianten, -alternativen und Abwandlungen beschrieben und in den Figuren veranschaulicht. Diese Beschreibungen und Darstellungen sind rein schematisch und schränken den Schutzumfang der Ansprüche nicht ein, sondern dienen nur deren beispielhafter Veranschaulichung. Es versteht sich, dass die Erfindung in dem durch die Patentansprüche vorgegebenen Umfang und Bereich auf vielfältige Weise ausgeführt und abgewandelt werden kann, ohne den Schutzumfang der Patentansprüche zu verlassen.

Beispielsweise ist die erfindungsgemäße Belüftungsvorrichtung 1 auch so einsetzbar, dass innerhalb der Luftleitkammern Radiallüfter mit einer internen axialradialen oder radial-axialen Strömungsumlenkung angeordnet sind, deren radialer Ab- oder Zustrom durch die Luftleitkammern in geeigneter Weise verteilt bzw. gesammelt wird, wobei der axiale Zu- oder Abstrom durch die Öffnungen 14a, 14b verläuft.

Die unter Bezug auf die dargestellten Ausführungsformen beschriebenen Merkmale der Erfindung, z.B. der gemeinsame Anschluss 24a gemäß Fig. 5, können auch bei anderen Ausführungsformen der Erfindung, z.B. in der Belüftungsanordnung gemäß Fig. 6 und/oder Fig. 7, vorhanden sein, außer wenn es anders angegeben ist oder sich aus technischen Gründen von selbst verbietet.

### Liste der Bezugszeichen und Symbole

- 1: Belüftungsvorrichtung
- 1a: Belüftungsseite
- 2: Leiterplatte
- 2a: erste Leiterplattenflachseite (Oberseite)
- 2b: zweite Leiterplattenflachseite (Unterseite)
- 3: Bauteil(e)
- 4: Frischluftstrom
- 5: erster Kühlluftstrom
- 6: Frischluftstrom
- 7: zweiter Kühlluftstrom
- 8: Abluftstrom
- 9: Wand
- 10: Umlenkstrom
- 11: Gehäuse
- 12: erster Lüfter
- 12a: Lüfteranschluss
- 13: zweiter Lüfter
- 13a: Lüfteranschluss
- 14: Trägerplatte
- 14a: erste Öffnung
- 14b: zweite Öffnung
- 15: Schrauben
- 16: erster Steg
- 16a: erste Trennwand
- 16b: Rückwand
- 16c: Seitenwand
- 16d: Vorderwand
- 16e: Seitenwand
- 17: erste Deckplatte
- 18: zweiter Steg
- 18a: zweite Trennwand
- 18b: Rückwand
- 18c: Seitenwand
- 18d: Vorderwand
- 18e: Seitenwand
- 19: zweite Deckplatte
- 20: erste Nebenkammer
- 21: zweite Nebenkammer
- 22: erste Luftleitkammer
- 23: zweite Luftleitkammer
- 24: Symmetrischer Anschluss
- 24a: Massepol
- 24b: erster Pluspol
- 24c: zweiter Pluspol
- 24d: Formmerkmal

- 100: Leiterplatte (Stand der Technik)
- 101: Bauteil
- 102: Lüftereinheit
- 103: Luftstrom

- BL: Belüftungsebene
- L: Luftstromgrenzebene / Leiterplattenebene

Die vorstehende Liste ist integraler Bestandteil der Beschreibung.

## Patentansprüche

1. Belüftungsvorrichtung (1) zum Belüften einer Leiterplatte (2) in einem bzw. für einen Computer, wobei die Belüftungsvorrichtung (1) ausgebildet ist, um mittels eines ersten Lüfters (12) einen ersten Kühlluftstrom (5) zu erzeugen und mittels eines zweiten Lüfters (13) einen zweiten Kühlluftstrom (7) zu erzeugen, wobei der erste Kühlluftstrom (5) und der zweite Kühlluftstrom (7) auf unterschiedlichen Seiten einer Luftstromgrenzebene (L) vorzugsweise parallel zu der Luftstromgrenzebene (L) durch eine gemeinsame, zu der Luftstromgrenzebene (L) senkrechte Belüftungsebene (BL) hindurch verlaufen, wobei Förderrichtungen des ersten Lüfters (12) und des zweiten Lüfters (13) quer zu der Luftstromgrenzebene (L) verlaufen, wobei die Belüftungsvorrichtung (1) so montierbar ausgebildet ist, dass die Luftstromgrenzebene (L) mit einer Mittelebene der Leiterplatte (2) zusammenfällt **dadurch gekennzeichnet, dass** die Belüftungsvorrichtung (1) ein Gehäuse mit einer Belüftungsseite (1a), welche die Belüftungsebene (BL) definiert und an welcher das Gehäuse wenigstens teilweise offen ist, und eine Trägerplatte (14), welche die Belüftungsseite (1a) teilt und die Luftstromgrenzebene (L) definiert, aufweist, wobei die Trägerplatte (14) wenigstens zwei Lüfter (12, 13) derart trägt oder zur Aufnahme wenigstens zweier Lüfter (12, 13) derart ausgebildet ist, dass durch jeden Lüfter (12, 13) ein Luftstrom (4, 6; 4, 7) durch eine jeweilige Öffnung (14a, 14b) der Trägerplatte (14) hindurch gefördert wird bzw. förderbar ist, wobei jedem der Lüfter (12, 13) eine jeweilige Luftleitkammer (22, 23) zugeordnet ist, die zu der Belüftungsseite (1a) hin offen und zu allen anderen Seiten hin mit Ausnahme der jeweiligen Öffnung (14a, 14b) der Trägerplatte (14) geschlossen oder im Wesentlichen geschlossen ist, dass die Lüfter (12, 13) auf unterschiedlichen Seiten der Trägerplatte (14) vorgesehen sind, und
dass jede Luftleitkammer (22, 23) eines der Lüfter (12, 13) auf ihrer Seite der Trägerplatte (14) von einem Bereich eines anderen der Lüfter (12, 13) abgeteilt ist, wobei zum Abteilen insbesondere jeweils eine Trennwand (16a, 18a) vorgesehen ist, welche sich vorzugsweise senkrecht auf der Trägerplatte (14) und besonders bevorzugt schräg zu der Belüftungsseite (1a) erstreckt.

2. Belüftungsvorrichtung (1) gemäß Anspruch 1, wobei der erste Kühlluftstrom (5) und der zweite Kühlluftstrom (7) Druckströme oder Saugströme des ersten Lüfters (12) bzw. des zweiten Lüfters (13) sind.

3. Belüftungsvorrichtung (1) gemäß Anspruch 1, wobei der erste Kühlluftstrom (5) ein Druckstrom des ersten Lüfters (12) bzw. des zweiten Lüfters (13) ist und der zweite Kühlluftstrom (7) ein Saugstrom des anderen, d.h. des zweiten Lüfters (13) bzw. des ersten Lüfters (12) ist.

4. Belüftungsvorrichtung (1) gemäß einem der Ansprüche 1 bis 3, wobei die Trägerplatte (14) ein Abschnitt einer Leiterplatte (2), insbesondere der zu belüftenden Leiterplatte (2), ist.

5. Belüftungsvorrichtung (1) gemäß einem der Ansprüche 1 bis 4, wobei das Gehäuse wenigstens eines der folgenden Werkstoffe aufweist oder daraus hergestellt ist oder im Wesentlichen hergestellt ist:
• Kunststoff, insbesondere ABS, PC oder ein Gemisch davon,
• Leiterplattenmaterial,
• Metall, insbesondere Aluminium oder Stahlblech,
• Karton, Papier, Pappe oder dergleichen.

6. Belüftungsvorrichtung (1) gemäß einem der vorstehenden Ansprüche, wobei zur elektrischen Stromversorgung der Lüfter (12, 13) ein symmetrischer Anschluss (24) vorgesehen ist, wobei der Anschluss vorzugsweise einen gemeinsamer Minuspol (24a) als Masse und jeweilige Pluspole (24b, 24c) als Versorgungspotential jeweils eines der Lüfter (12, 13) in symmetrischer Anordnung um den Minuspol (24a) herum aufweist.

7. Verfahren zum Belüften einer Leiterplatte (2) in einem bzw. für einen Computer durch eine Belüftungsvorrichtung (1) mit den folgenden Schritten:
- Erzeugen eines ersten Kühlluftstroms (5) mittels eines ersten Lüfters (12) und eines zweiten Kühlluftstrom (7) mittels eines zweiten Lüfters (13), wobei der erste Kühlluftstrom (5) und der zweite Kühlluftstrom (7) auf unterschiedlichen Seiten einer Luftstromgrenzebene (L) in der Belüftungsvorrichtung (1) vorzugsweise parallel zu der Luftstromgrenzebene (L) durch eine gemeinsame, zu der Luftstromgrenzebene (L) senkrechte Belüftungsebene (BL) hindurch verlaufen,
**gekennzeichnet durch** weitere Schritte und Merkmale:
- Verlaufen der Förderrichtungen des ersten Lüfters (12) und des zweiten Lüfters (13) quer zu der Luftstromgrenzebene (L), und
- Einstellen des Belüftens derart, dass die Luftstromgrenzebene (L) der Belüftungsvorrichtung (1) mit einer Mittelebene der Leiterplatte (2) zusammenfällt,
dass die Belüftungsvorrichtung (1) ein Gehäuse mit einer Belüftungsseite (1a), welche die Belüftungsebene (BL) definiert und an welcher das Gehäuse wenigstens teilweise offen ist, und eine Trägerplatte (14), welche die Belüftungsseite (1a) teilt und die Luftstromgrenzebene (L) definiert, aufweist, wobei die Trägerplatte (14) wenigstens zwei Lüfter (12, 13) derart trägt oder zur Aufnahme wenigstens zweier Lüfter (12, 13) derart ausgebildet ist, dass durch jeden Lüfter (12, 13) ein Luftstrom (4, 6; 4, 7) durch eine jeweilige Öffnung (14a, 14b) der Trägerplatte (14) hindurch gefördert wird bzw. förderbar ist, wobei jedem der Lüfter (12, 13) eine jeweilige Luftleitkammer (22, 23) zugeordnet ist, die zu der Belüftungsseite (1a) hin offen und zu allen anderen Seiten hin mit Ausnahme der jeweiligen Öffnung (14a, 14b) der Trägerplatte (14) geschlossen oder im Wesentlichen geschlossen ist, dass die Lüfter (12, 13) auf unterschiedlichen Seiten der Trägerplatte (14) vorgesehen sind, und
dass jede Luftleitkammer (22, 23) eines der Lüfter (12, 13) auf ihrer Seite der Trägerplatte (14) von einem Bereich eines anderen der Lüfter (12, 13) abgeteilt ist, wobei zum Abteilen insbesondere jeweils eine Trennwand (16a, 18a) vorgesehen ist, welche sich vorzugsweise senkrecht auf der Trägerplatte (14) und besonders bevorzugt schräg zu der Belüftungsseite (1a) erstreckt.

8. Verfahren gemäß Anspruch 7, **dadurch gekennzeichnet, dass** die Belüftungsvorrichtung (1) in zwei Betriebsarten betreibbar ist, wobei in einer ersten Betriebsart der erste Lüfter (12) und der zweite Lüfter (13) in einer Push- bzw. Pull-Belüftung arbeiten, während in einer zweiten Betriebsart der erste Lüfter (12) und der zweite Lüfter (13) in einer sogenannten Push-Pull-Belüftung arbeiten, so dass in der zweiten Betriebsart der erste Kühlluftstrom (5) ein Druckstrom des ersten Lüfters (12) bzw. des zweiten Lüfters (13) ist und der zweite Kühlluftstrom (7) ein Saugstrom des anderen, d.h. des zweiten Lüfters (13) bzw. des ersten Lüfters (12) ist.

9. Verfahren gemäß Anspruch 8, **dadurch gekennzeichnet, dass** in der ersten Betriebsart der Belüftungsvorrichtung (1) ein Frischluftstrom (4) durch eine Öffnung an der Unterseite der Belüftungsvorrichtung (1) durch den ersten Lüfter (12) angesaugt, innerhalb der Belüftungsvorrichtung (1) durch geeignete Luftführungselemente umgelenkt und oberhalb der Leiterplattenebene (L) als der erste Kühlluftstrom (5) durch eine Öffnung auf der Belüftungsseite (1a) der Belüftungsvorrichtung (1) so abgegeben wird, dass er die Belüftungsvorrichtung (1) unter Hindurchtreten durch die Belüftungsebene (BL) parallel zu der Leiterplattenebene (L) an der Oberseite (2a) der Leiterplatte (2) verlässt, dass gleichermaßen ein zweiter Frischluftstrom (6) durch eine Öffnung an der Oberseite der Belüftungsvorrichtung (1) angesaugt, innerhalb der Belüftungsvorrichtung durch geeignete Luftführungselemente umgelenkt und unterhalb der Leiterplattenebene (L) als der zweite Kühlluftstrom (7) zur Belüftung der Unterseite (2b) der Leiterplatte (2) durch eine Öffnung an der Belüftungsseite (1a) der Belüftungsvorrichtung (1) so abgegeben wird, dass er die Belüftungsvorrichtung (1) unter Hindurchtreten durch die Belüftungsebene (BL) parallel zu der Leiterplattenebene (L) an der Unterseite (2b) der Leiterplatte (2) verlässt, und
dass nach Überströmen der Leiterplatte (2) sich der erste Kühlluftstrom (5) und der zweite Kühlluftstrom (7) zu einem Abluftstrom (8) vereinigen kann, der beispielsweise ein Rechnergehäuse durch Lüftungsschlitze verlassen kann.

10. Verfahren gemäß Anspruch 8 oder 9, **dadurch gekennzeichnet, dass** in der zweiten Betriebsart der Belüftungsvorrichtung (1) auf einer der Belüftungsvorrichtung (1) entgegengesetzten Schmalseite der Leiterplatte (2) durch eine Gehäusewand (9) des Computers oder ein anderes Hindernis eine Umlenkung des ersten Kühlluftstromes (5) in einen Umlenkstrom (10) bewirkt wird, der durch die Saugwirkung des zweiten Kühlluftstrom (7) des im Pull-Betrieb arbeitenden Lüfters (13, 12) unterstützt wird.

## Claims

1. A ventilation device (1) for ventilation of a printed circuit board (2) in or for a computer, wherein the ventilation device (1) is designed to generate a first cooling air stream (5) by means of a first blower (12) and a second cooling air stream (7) by means of a second blower (13), wherein the first cooling air stream (5) and the second cooling air stream (7) pass through a common ventilation layer (BL) perpendicular to the air stream boundary plane (L) on different sides of an air stream boundary plane (L), preferably parallel to the air stream boundary plane (L), wherein
the delivery directions of the first blower (12) and the second blower (13) are perpendicular to the air stream boundary plane (L), wherein the ventilation device (1) is designed to be mountable in such a way that the air stream boundary plane (L) coincides with a center plane of the printed circuit board (2), **characterized in that**
the ventilation device (1) comprises a housing with a ventilation side (1a), which defines the ventilation layer (BL) and toward which the housing is at least partially open, and a mounting plate (14), which divides the ventilation side (1a) and defines the air stream boundary plane (L), wherein the mounting plate (14) supports at least two blowers (12, 13) or is designed to accommodate at least two blowers (12,13) in such a manner that through each blower (12, 13) an air stream (4, 6; 4, 7) is delivered or can be delivered through a respective opening (14a, 14b) in the mounting plate (14), wherein each of the blowers (12, 13) is assigned to a respective air guide chamber (22, 23) that is open toward the ventilation side (1a) and is closed or substantially closed on all other sides except for the respective opening (14a, 14b) of the mounting plate (14), that the blowers (12, 13) are provided on different sides of the mounting plate (14), and
that each air guide chamber (22, 23) of one of the blowers (12, 13) on its side of the mounting plate (14) is divided off from an area of another of the blowers (12, 13), wherein for the division in each case particularly a partition (16a, 18a) is provided, which preferably extends perpendicularly on the mounting plate (14) and particularly preferably at an angle to the ventilation side (1 a).

2. The ventilation device (1) according to claim 1, wherein the first cooling air stream (5) and the second cooling air stream (7) are push streams or pull streams of the first blower (12) or the second blower (13).

3. The ventilation device (1) according to claim 1, wherein the first cooling air stream (5) is a push stream of the first blower (12) or the second blower (13) and the second cooling air stream (7) is a pull stream of the other, i.e., the second blower (13) or the first blower (12) .

4. The ventilation device (1) according to any one of claims 1 to 3, wherein the mounting plate (14) is a section of a printed circuit board (2), especially the printed circuit board (2) to be ventilated.

5. The ventilation device (1) according to any one of claims 1 to 4, wherein the housing contains or is made from or is substantially made from one or more of the following materials:
• plastic, especially ABS, PC or a mixture thereof,
• printed circuit board material,
• metal, especially aluminum or steel plate,
• cardboard, paper, paperboard or the like.

6. The ventilation device (1) according to any one of the preceding claims, wherein for supplying electric current to the blower (12, 13) a symmetrical connection (24) is provided, wherein the connection preferably has a shared negative terminal (24a) as ground and the respective positive terminals (24b, 24c) as the supply potential of one of the blowers (12, 13) in each case, in a symmetrical arrangement around the negative terminal (24a) .

7. A process for ventilation of a printed circuit board (2) in or for a computer using a ventilation device (1) with the following steps:
- producing a first cooling air stream (5) by means of a first blower (12) and a second cooling air stream (7) by means of a second blower (13), wherein the first cooling air stream (5) and the second cooling air stream (7) pass on different sides of an air stream boundary plane (L) in the ventilation device (1), preferably in parallel to the air stream boundary plane (L) through a common ventilation layer (BL) perpendicular to the air stream boundary plane (L),
**characterized by** additional steps and features:
- deflection of the delivery directions of the first blower (12) and the second blower (13) perpendicular to the air stream boundary plane (L), and
- regulation of the ventilation such that the air stream boundary plane (L) of the ventilation device (1) coincides with a center plane of the printed circuit board (2), that the ventilation device (1) has a housing with a ventilation side (1a) which defines the ventilation layer (BL) and at which the housing is at least partially open, and a mounting plate (14) which divides the ventilation side (1a) and defines the air stream boundary plane (L), wherein the mounting plate (14) supports at least two blowers (12, 13) in such a manner or is designed to support at least two blowers (12,13) in such a manner that through each blower (12, 13) an air stream (4, 6; 4, 7) is delivered or is deliverable through a respective opening (14a, 14b) in the mounting plate (14), wherein each of the blowers (12, 13) is assigned to a respective air guide chamber (22, 23) that is open toward the ventilation side (1a) and closed or substantially closed toward all other sides except for the respective opening (14a, 14b) of the mounting plate (14), that the blowers (12, 13) are provided on different sides of the mounting plate (14), and
that each air guide chamber (22, 23) of one of the blowers (12, 13) on its side of the mounting plate (14) is divided from an area of the another one of the blowers (12, 13), wherein for dividing them, in each case especially a partition (16a, 18a) is provided, which preferably extends perpendicularly on the mounting plate (14) and particularly preferably extends at an angle to the ventilation side (1 a).

8. The process according to claim 7, **characterized in that** the ventilation device (1) can be operated in two operating modes, wherein in a first operating mode the first blower (12) and the second blower (13) operate in push or pull ventilation, while in a second operating mode the first blower (12) and the second blower (13) operate in a so-called push-pull ventilation, so that in the second operating mode the first cooling air stream (5) is a push stream of the first blower (12) or the second blower (13) and the second cooling air stream (7) is a pull stream of the other, i.e., the second blower (13) or the first blower (12).

9. The process according to claim 8, **characterized in that** in the first operating mode of the ventilation device (1) a fresh air stream (4) is pulled through an opening on the underside of the ventilation device (1) by the first blower (12), is deflected within the ventilation device (1) by suitable air guide elements and is released above the plane of the printed circuit board (L) as the first cooling air stream (5) through an opening on the ventilation side (1a) of the ventilation device (1) in such a manner that it exits the ventilation device (1) by passing through the ventilation layer (BL) parallel to the printed circuit board plane (L) on the upper side (2a) of the printed circuit board (2), that likewise a second fresh air stream (6) is drawn in through an opening on the upper side of the ventilation device (1), deflected inside of the ventilation device by suitable air guide elements, and released below the printed circuit board plane (L) as the second cooling air stream (7) for ventilating the underside (2b) of the printed circuit board (2) through an opening on the ventilation side
(1a) of the ventilation device (1) in such a manner that it exits the ventilation device (1) by passing through the ventilation plane (BL) parallel to the printed circuit board plane (L) on the underside (2b) of the printed circuit board (2), and
that after flowing over the printed circuit board (2), the first cooling air stream (5) and the second cooling air stream (7) can combine to form a waste air stream (8), which for example can leave a computer housing through ventilation slits.

10. The process according to claim 8 or 9, **characterized in that** in the second operating mode of the ventilation device (1), on a narrow side of the printed circuit board (2) opposite the ventilation device (1), deflection of the first cooling air stream (5) through a housing wall (9) of the computer or another obstacle into a deflected stream (10) is accomplished, supported by the suction effect of the second cooling air stream (7) of the blower (13, 12) operating in the pull operating mode.

## Revendications

1. Dispositif de ventilation (1) pour la ventilation d'un circuit imprimé (2) dans un ou pour un ordinateur, dans lequel le dispositif de ventilation (1) est réalisé pour générer un premier flux d'air de refroidissement (5) au moyen d'un premier ventilateur (12) et pour générer un second flux d'air de refroidissement (7) au moyen d'un second ventilateur (13), dans lequel le premier flux d'air de refroidissement (5) et le second flux d'air de refroidissement (7) passent sur différents côtés d'un plan limite de flux d'air (L) de préférence, parallèlement au plan limite de flux d'air (L) à travers un plan de ventilation (BL) commun perpendiculaire au plan limite de flux d'air (L), dans lequel des directions de transport du premier ventilateur (12) et du second ventilateur (13) s'étendent transversalement au plan limite de flux d'air (L), dans lequel le dispositif de ventilation (1) est réalisé de manière à pouvoir être monté de sorte que le plan limite de flux d'air (L) coïncide avec un plan médian du circuit imprimé (2), **caractérisé en ce que** le dispositif de ventilation (1) présente un boîtier avec un côté ventilation (1a), lequel définit le plan de ventilation (BL) et au niveau duquel le boîtier est ouvert au moins en partie, et une plaque de support (14), laquelle divise le côté ventilation (1a) et définit le plan limite de flux d'air (L), dans lequel la plaque de support (14) porte au moins deux ventilateurs (12, 13) ou est réalisée pour la réception d'au moins deux ventilateurs (12, 13) de sorte que, à travers chaque ventilateur (12, 13), un flux d'air (4, 6 ; 4, 7) est transporté ou peut être transporté à travers une ouverture (14a, 14b) respective de la plaque de support (14), dans lequel une chambre de conduite d'air (22, 23) respective est attribuée à chacun des ventilateurs (12, 13), laquelle chambre est ouverte vers le côté ventilation (1a) et fermée ou sensiblement fermée vers tous les autres côtés à l'exception de l'ouverture (14a, 14b) respective de la plaque de support (14),
**que** les ventilateurs (12, 13) sont prévus sur différents côtés de la plaque de support (14), et
**que** chaque chambre de conduite d'air (22, 23) d'un des ventilateurs (12, 13) est séparée sur son côté de la plaque de support (14) d'une zone d'un autre des ventilateurs (12, 13), dans lequel en particulier respectivement une cloison de séparation (16a, 18a) est prévue pour la séparation, laquelle cloison s'étend de préférence perpendiculairement sur la plaque de support (14) et de manière particulièrement préférée en biais par rapport au côté ventilation (la).

2. Dispositif de ventilation (1) selon la revendication 1, dans lequel le premier flux d'air de refroidissement (5) et le second flux d'air de refroidissement (7) sont des flux de pression ou flux d'aspiration du premier ventilateur (12) ou du second ventilateur (13).

3. Dispositif de ventilation (1) selon la revendication 1, dans lequel le premier flux d'air de refroidissement (5) est un flux de pression du premier ventilateur (12) ou du second ventilateur (13) et le second flux d'air de refroidissement (7) est un flux d'aspiration de l'autre, autrement dit du second ventilateur (13) ou du premier ventilateur (12).

4. Dispositif de ventilation (1) selon l'une quelconque des revendications 1 à 3, dans lequel la plaque de support (14) est une section d'un circuit imprimé (2), en particulier du circuit imprimé (2) à ventiler.

5. Dispositif de ventilation (1) selon l'une quelconque des revendications 1 à 4, dans lequel le boîtier présente au moins l'un des matériaux suivants ou est fabriqué ou est sensiblement fabriqué à partir de ceux-ci :
- plastique, en particulier ABS, PC ou un mélange de ceux-ci,
- matériau de circuit imprimé,
- métal, en particulier aluminium ou tôle d'acier,
- carton, papier, carton ou similaire.

6. Dispositif de ventilation (1) selon l'une quelconque des revendications précédentes, dans lequel un raccord symétrique (24) est prévu pour l'alimentation en courant électrique des ventilateurs (12, 13), dans lequel le raccord présente de préférence un pôle moins commun (24a) en tant que masse et un pôle plus respectif (24b, 24c) en tant que potentiel d'alimentation respectivement de l'un des ventilateurs (12, 13) en agencement symétrique autour du pôle moins (24a)

7. Procédé de ventilation d'un circuit imprimé (2) dans un ou pour un ordinateur par un dispositif de ventilation (1) avec les étapes suivantes :
- la génération d'un premier flux d'air de refroidissement (5) au moyen d'un premier ventilateur (12) et d'un second flux d'air de refroidissement (7) au moyen d'un second ventilateur (13), dans lequel le premier flux d'air de refroidissement (5) et le second flux d'air de refroidissement (7) passent sur différents côtés d'un plan limite de flux d'air (L) dans le dispositif de ventilation (1), de préférence parallèlement au plan limite de flux d'air (L) à travers un plan de ventilation (BL) commun perpendiculaire au plan limite de flux d'air (L),
**caractérisé par** d'autres étapes et caractéristiques :
- le passage des directions de transport du premier ventilateur (12) et du second ventilateur (13) transversalement au plan limite de flux d'air (L), et
- le réglage de la ventilation de sorte que le plan limite de flux d'air (L) du dispositif de ventilation (1) coïncide avec un plan médian du circuit imprimé (2),
que le dispositif de ventilation (1) présente un boîtier avec un côté ventilation (1a), lequel définit le plan de ventilation (BL) et au niveau duquel le boîtier est ouvert au moins en partie, et une plaque de support (14), laquelle divise le côté ventilation (1a) et définit le plan limite de flux d'air (L), dans lequel la plaque de support (14) porte au moins deux ventilateurs (12, 13) ou est réalisée pour la réception d'au moins deux ventilateurs (12, 13) de sorte que, à travers chaque ventilateur (12, 13), un flux d'air (4, 6 ; 4, 7) est transporté ou peut être transporté à travers une ouverture (14a, 14b) respective de la plaque de support (14), dans lequel une chambre de conduite d'air (22, 23) respective est attribuée à chacun des ventilateurs (12, 13), laquelle chambre est ouverte vers le côté ventilation (1a) et fermée ou sensiblement fermée vers tous les autres côtés à l'exception de l'ouverture (14a, 14b) respective de la plaque de support (14)
que les ventilateurs (12, 13) sont prévus sur différents côtés de la plaque de support (14), et
que chaque chambre de conduite d'air (22, 23) d'un des ventilateurs (12, 13) est séparée, sur son côté de la plaque de support (14), d'une zone d'un autre des ventilateurs (12, 13), dans lequel en particulier respectivement une cloison de séparation (16a, 18a) est prévue pour la séparation, laquelle cloison s'étend de préférence perpendiculairement sur la plaque de support (14) et de manière particulièrement préférée en biais par rapport au côté ventilation (1a).

8. Procédé selon la revendication 7, **caractérisé en ce que** le dispositif de ventilation (1) peut fonctionner dans deux modes de fonctionnement, dans lequel, dans un premier mode de fonctionnement, le premier ventilateur (12) et le second ventilateur (13) fonctionnent dans une ventilation push ou pull,
pendant que, dans un second mode de fonctionnement, le premier ventilateur (12) et le second ventilateur (13) fonctionnent dans une ventilation dite push-pull, de sorte que dans le second mode de fonctionnement, le premier flux d'air de refroidissement (5) est un flux de pression du premier ventilateur (12) ou du second ventilateur (13) et le second flux d'air de refroidissement (7) est un flux d'aspiration de l'autre, autrement dit du second ventilateur (13) ou du premier ventilateur (12).

9. Procédé selon la revendication 8, **caractérisé en ce que**, dans le premier mode de fonctionnement du dispositif de ventilation (1), un flux d'air frais (4) est aspiré par une ouverture au niveau d'un côté inférieur du dispositif de ventilation (1) par le premier ventilateur (12), dévié à l'intérieur du dispositif de ventilation (1) par des éléments de guidage d'air adaptés et rejeté au-dessus du plan de circuit imprimé (L) en tant que premier flux d'air de refroidissement (5) par une ouverture sur le côté aspiration (1a) du dispositif de ventilation (1) de sorte qu'il quitte le dispositif de ventilation (1) en traversant le plan de ventilation (BL) parallèlement au plan de circuit imprimé (L) au niveau du côté supérieur (2a) du circuit imprimé (2),
**que**, de la même manière, un second flux d'air frais (6) est aspiré par une ouverture au niveau du côté supérieur du dispositif de ventilation (1), dévié à l'intérieur du dispositif de ventilation par des éléments de guidage d'air adaptés et rejeté en-dessous du plan de circuit imprimé (L) en tant que second flux d'air de refroidissement (7) pour la ventilation de la face inférieure (2b) du circuit imprimé (2) par une ouverture au niveau du côté aspiration (1a) du dispositif de ventilation (1), de sorte qu'il quitte le dispositif de ventilation (1) en traversant le plan de ventilation (BL) parallèlement au plan de circuit imprimé (L) au niveau du côté inférieur (2b) du circuit imprimé (2), et qu'après le passage au-dessus du circuit imprimé (2), le premier flux d'air de refroidissement (5) et le second flux d'air de refroidissement (7) peuvent s'unir en un flux d'air d'évacuation (8), qui peut quitter par exemple un boîtier d'ordinateur par des fentes de ventilation.

10. Procédé selon la revendication 8 ou 9, **caractérisé en ce que**, dans le second mode de fonctionnement du dispositif de ventilation (1), une déviation du premier flux d'air de refroidissement (5) en un flux de déviation (10) est entraînée sur un côté étroit du circuit imprimé (2) opposé au dispositif de ventilation (1) par une paroi de boîtier (9) de l'ordinateur ou un autre obstacle, qui est soutenue par l'effet d'aspiration du second flux d'air de refroidissement (7) du ventilateur fonctionnant en mode Pull (13, 12).
